# EUROPEAN PATENT SPECIFICATION

(11) **EP 2 610 593 B1**
(45) Date of publication and mention of the grant of the patent: **12.02.2020**
(21) Application number: 11010266.2
(22) Date of filing: 29.12.2011
(51) Int. Cl.: H01L 21/68, G03F 7/20

(54) **Positioning system and method for positioning supporting means for supporting an article**
Positionierungssystem und Verfahren zur Positionierung von Hilfsmitteln zum Stützen eines ArtikelsPositionierungssystem
Système de positionnement et procédé pour positionner un moyen de support pour supporter un article

(43) Date of publication of application: 03.07.2013
(73) Proprietor: Robert Bosch GmbH, 70442 Stuttgart (DE)
(72) Inventor: ten Haat, Eric, 3900 Overpelt (NL)
(74) Representative: Thürer, Andreas

(56) References cited:
- EP-A1- 2 003 681
- WO-A1-97/30819
- US-A1- 2004 263 846

## Description

The present invention relates to a positioning system and a method for positioning supporting means. In particular, the present invention relates to a positioning system and a positioning method for positioning a stage holding a semiconductor wafer.

In the field of producing semiconductor devices, for example semiconductor chips with Integrated circuits, semiconductor wafers are positioned on a stage so that they can be treated with specific handling means, like a laser or etching means. In the course of treating the wafer to produce the desired electric circuit element or electric circuitry on the wafer, it is required that the wafer is positioned at a predefined position. Whether or not the wafer is positioned at the right predefined position is usually determined by a sensor. Since the element(s) to be produced on the wafer has/have dimensions in the area of nanometers or less, for example, the sensor has to provide a high precision signal.

For supporting a positioning of the wafer at the predefined position during the production process, a linear motor can be used. The motor moves the stage with the wafer thereon along a linear line. Therefore, usually a scale is mounted along the entire linear line. The scale can be read by a read head to determine the actual position of the stage and therewith the wafer mounted thereon. Due to such a construction, the scale is provided along the entire way the stage with the wafer can be moved.

However, providing one long scale along the entire way the stage with the wafer can be moved increases the costs of positioning the stage with the wafer essentially. Such long scales with the needed very high accuracy are very expensive. In addition, such long scales are difficult to produce and difficult to assemble in a machine for producing the circuitry on the wafer.

EP 2 003 681 A1 shows a measuring device and method in which position information of a movable body within an XY plane is measured with high accuracy by an encoder system.

It is an object of the present invention to provide a positioning system and a positioning method for positioning a supporting means which can solve the above mentioned problems. In particular, it is an object of the present invention to provide a positioning system and a positioning method which can simplify the assembling of the machine for producing a circuitry on a wafer and can provide a machine for producing a circuitry on a wafer which is less expensive.

This object is solved by a positioning system according to the features of claim 1. The positioning system comprises a positioning device for positioning supporting means for supporting an article, and a supporting means for supporting an article, to be positioned, wherein the positioning device comprises at least two scales for measuring the position of said supporting means, and at least two read heads for reading said at least two scales, wherein each one of said at least two read heads is positioned such that at least one of said at least two read heads can read one scale of said at least two scales, as given in claim 1.

The above described positioning system does not have a long encoder scale alongside a linear motor. Instead, a number of short encoder scales is used. Therefore, the provided positioning system is much cheaper than devices known in the art. As a result, the price of a machine for producing a circuitry on a wafer, which has the above described positioning device, is reduced essentially.

Further, in the above described positioning system, the required accuracy of assembling the multiple scales is not very high compared to the required accuracy for mounting a long scale. This is due to the fact that one read head, which could not read a scale for a certain motion length and/or time duration, will adopt its position from a read head which could read a scale for that certain motion length and/or time duration.

Further advantageous developments of the positioning system are set out in the dependent claims.

The positioning system can further comprise a mark arranged between said at least two scales.

The positioning device, in said positioning system, advantageously comprises at least two read heads positioned to read a scale which is different from a scale which can be read by another one of said at least two read heads.

The positioning device can further comprise at least two read heads arranged such that, when one read head enters a range for reading one of said at least two scales, said read head adopts its reading result from one of the other at least two read heads which is reading another scale of the at least two scales.

It is possible that the at least two read heads are arranged at said supporting means.

The supporting means can be a stage for supporting a wafer and/or the scales are scales for measuring dimensions in the range of millimeters to picometers.

The positioning system is advantageously a part of a machine for treating a semiconductor wafer. The machine can further have supporting means for supporting the semiconductor wafer. Herein, the positioning system is usable for positioning the semiconductor wafer in the machine.

The above mentioned object is further solved by a positioning method for positioning a supporting means according to the features of claim 8. The positioning method comprises the steps of: Measuring the position of said supporting means by the use of at least two scales, and reading said at least two scales by at least two read heads, wherein each one of said at least two read heads is positioned such that at least one of said at least two read heads can read one scale of said at least two scales, as given in claim 8.

The above described positioning method is performed by the above described positioning system. Therefore, the positioning method provides the same advantages as mentioned above for the positioning system.

Further possible implementations of the invention also comprise combinations of specific features described above or in the following as regards embodiments, even if they are not explicitly mentioned. Therefore, the person skilled in the art will also add single aspects as improvements or supplements to the basic form of the invention which is defined by the appended claims.

In the following, the present invention is described in more detail with the aid of embodiments by reference to the appended drawings. The figures show:
- Fig. 1: a schematic diagram for explaining a machine having a positioning system according to a first embodiment;
- Fig. 2: a schematic diagram for explaining the function of the positioning system according to the first embodiment;
- Fig. 3: a further schematic diagram for explaining the function of the positioning system according to the first embodiment;
- Fig. 4: a still further schematic diagram for explaining the function of the positioning system according to the first embodiment;
- Fig. 5: a schematic diagram for explaining the calculation of the handover zone according to an example applicable in the first embodiment;
- Fig. 6: a flow chart for explaining a method according to the first embodiment; and
- Fig. 7: a schematic diagram for explaining a machine having a positioning system according to a second embodiment.

In the figures, similar elements or elements having similar function are marked with the same reference signs unless specified otherwise.

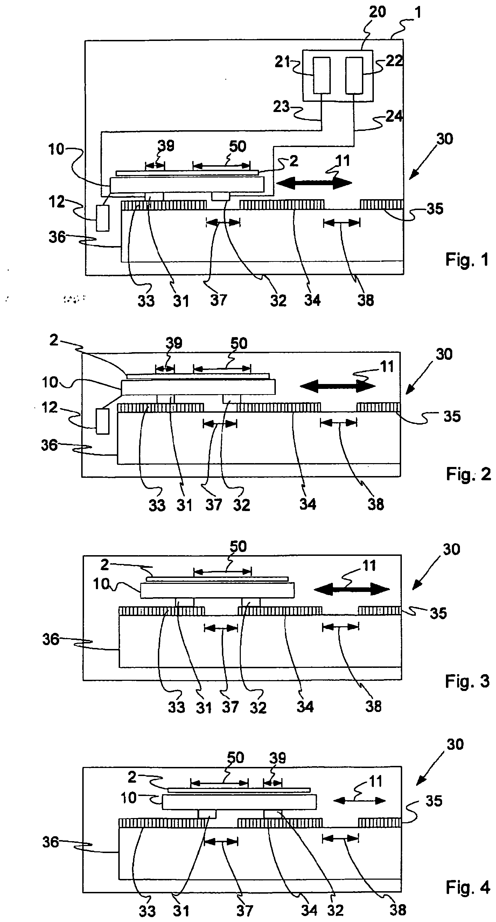

Fig. 1 shows a machine 1 for producing a semiconductor chip on the basis of a semiconductor wafer 2. The machine 1 comprises supporting means 10, control means 20, and a positioning device 30. In Fig. 1, the supporting means 10 is movable in a motion direction 11, which is shown in Fig. 1 by a black arrow. That is, the supporting means 10 is driven together with the semiconductor wafer 2 mounted thereon along a linear line in reciprocating motion. The supporting means 10 is movable by driving means 12, which may be a linear motor.

The positioning device 30 in Fig. 1 includes a first read head 31, a second read head 32, a first scale 33, a second scale 34, a third scale 35, and a base frame 36 on which the first to third scales 33, 34, 35 are mounted. The first and second read heads 31, 32 are mounted in Fig. 1 at the supporting means 10 such that they can read the respective scales 33, 34, 35, when the first and second read heads 31, 32 are moved together with the supporting means 10 in the direction 11. The first scale 33 and the second scale 34 are mounted with a space 37 in between. The second scale 34 and the third scale 35 are mounted with the space 38 in between. The read heads 31, 32 have a length 39 in the motion direction 11. The reference sign 50 denotes a handover zone which is explained in the following.

The first and second read heads 31, 32 are controlled by the control means 20. For this purpose, the control means 20 comprises a first port 21 and a second port 22. The first port 21 is connected via a first connection line 23 with the first read head 31. The second port 22 is connected via the second connection line 24 with the second read head 32. The first read head 31 can send the read information via the connection line 23 to the control means 20. Further, the control means 20 can send a control signal via the first connection line 23 to the first read head 31. The second read head 32 can send the read information via the second connection line 24 to the control means 20. The control means 20 can send a control signal via the second connection line 24 to the second read head 32. It is also possible that the first and/or second read head(s) 31, 32 read(s) i.e. see(s) lines on one of the scales 33, 34, 35, which are counted by the control means 20. The position as counted by one of the read heads 31, 32 is then added as an offset to the position of the other one of the read heads 31, 32. Thus, all this happens in the control means 20.

As shown In Fig. 1, only the first read head 31 is positioned over the first scale 33, whereas the second read head 32 is positioned over the space 37. Due to this, the second read head 32 can read none of the scales 33, 34, 35. Thus, the motion of the supporting means 10 is controlled on the basis of the reading result provided by the first read head 31, i.e. a detection performed with the first read head 31. The second read head 32 is positioned in the handover zone 50 where it cannot read the second scale 34. The area, where the second read head 32 can read the second scale 34 is adjacent to the handover zone 50 and is also called "range for reading one of at least two scales" in the claims.

Fig. 2 shows a state in which the supporting means 10 is already moved a little bit further to the right in Fig. 2 compared to the state shown in Fig. 1. At the state shown in Fig. 2, the supporting means 10 is positioned such that the second read head 32 started to enter the range of the second scale 34. That is, a part of the second read head 32 is already positioned over the second scale 34 whereas the other part of the second read head 32 is still positioned over the space 37. At that state, the second read head 32 can still not read the second scale 34. The second read head 32 is still positioned in the handover zone 50.

Fig. 3 shows a state, where the supporting means 10 is again moved a little bit further to the right in Fig. 3 compared to the state shown in Fig. 2. At the state shown in Fig. 3, both, the first and second read heads 31, 32 are positioned over a scale. In Fig. 3 the first read head 31 is still positioned over the first scale 33, whereas the second read head 32 is now entirely positioned over the second scale 34. At such a state, the second read head 32 started to leave the handover zone 50. Thus, it will adopt its reading result from the first read head 31. Therefore, both read heads 31, 32 deliver the same reading result to the control means 20.

Fig. 4 shows a state, where the supporting means 10 is again moved a little bit further to the right in Fig. 4 compared to the state shown in Fig. 3. At the state shown in Fig. 4, the second read head 32 is still positioned completely over the second scale 34, whereas the first read head 31 is now only positioned in part over the first scale 33. The other part of the first read head 31 Is positioned over the space 37. Due to this, at the state shown in Fig. 4, the first read head 31 is now in the handover zone 50. Therefore, only the signal of the second read head 32 is now decisive for the control means 20 for controlling the position of the supporting means 10.

Due to this, in the case that both of the read heads 31, 32 have the same length 39, the handover zone 50 is defined as the length of the space 37 plus two times the length 39. That is, for example, the handover zone 50 is defined as being approximately the length of the space 37 plus the length between the position where the right side of the second read head 32 starts to leave the first scale 33 up to a position where the left side of the second read head 32 starts to enter the space 37 and plus the length between the position where the right side of the second read head 32 starts to enter the second scale 34 up to a position where the left side of the second read head 32 entered the second scale 34, so that the second read 32 is completely positioned over the second scale 34.

The handover zone 50 is defined in the same way as concerns the first read head 31 and the respective scales 33, 34, 35 even if the handover zone 50 is not depicted in the figures as concerns the space 38.

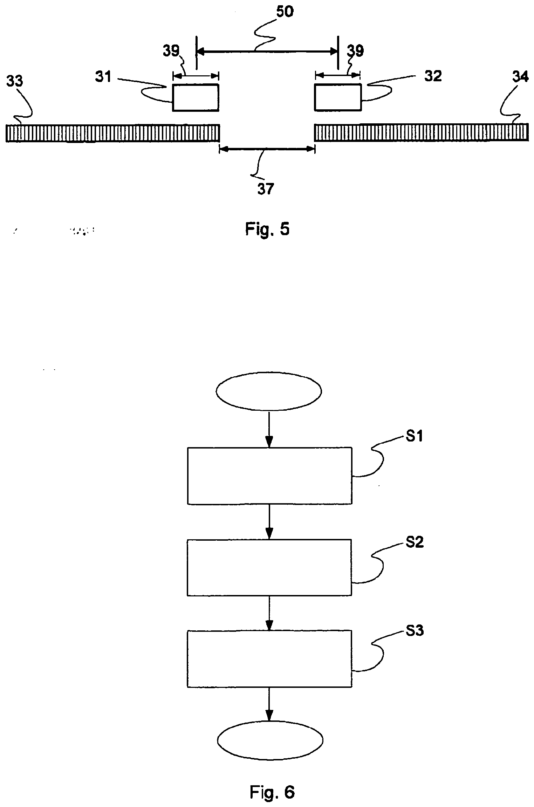

Fig. 5 illustrates another example for defining the handover zone 50. In Fig. 5, the first read head 31 is in the last "valid position" before leaving the first scale 33, whereas the second read head 32 is in the first "valid position" after entering the second scale 34. "Valid position" means a position where a read head 31, 32 can read a scale 33, 34, 35. Here, the "position of the read head" 31, 32 is defined at its center. Thus, the handover zone 50 is defined as the length of the space 37 plus two times half the length 39, as shown In Fig. 5.

Fig. 6 shows a method for positioning the supporting means 10. After the start of the method, the position of the supporting means 10 is measured using the first to third scale 33, 34, 35 in a step S1. Thereafter, a step S2 follows.

In the step S2, the scales of the first to third scales 33, 34, 35 are read by the first and second read heads 31, 32, over which the respective read heads 31, 32 are positioned. In case no scale is positioned such that it can be read by one of the read heads 31, 32, as shown in Fig. 1 for the second read head 32, for example, only the other one of the first and second read heads 31, 32 will send a reading result to the control means 20. That is, each of the first and second read heads 31, 32 is positioned such that at least one of the first and second read heads 31, 32 can read one of the scales 33, 34, 35.

Thereafter, the flow is continued with a step S3.

In the step S3, one of the read heads 31, 32 adopts the reading result of another read head, when this one read head passes the handover zone 50, as described above with reference to Fig. 3. Thereafter, the flow goes back to the step S1.

The method ends, when the positioning of the supporting means 10 in the machine 1 ends.

As described above, each one of the two read heads 31, 32 is positioned such that one of the at least two scales 33, 34, 35 can be read by at least one of the at least two read heads 31, 32.

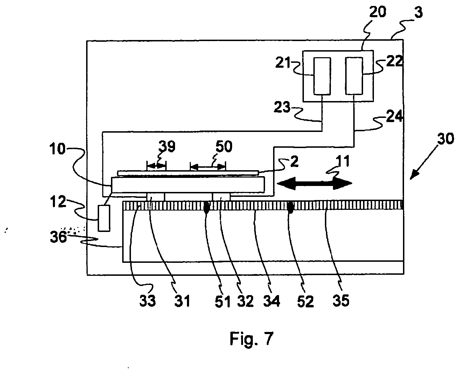

Fig. 7 shows a machine 3 for producing a semiconductor chip on the basis of the wafer 2 according to the second embodiment. The machine 3 is arranged in many aspects in the same way as the machine 1 of the first embodiment. Therefore, in the following, a description is made only for the aspects which are different from the machine 1 of the first embodiment.

In Fig. 7, the first to third scales 33, 34, 35 are mounted very close to each other. The position where the first scale 33 and the second scale 34 are mounted beside each other is marked with a mark 51. The position where the second scale 34 and the third scale 35 are mounted beside each other is marked with a mark 52.

That is, there is no space 37 (Fig. 1) between the first scale 33 and the second scale 34 or between the second scale 34 and the third scale 35. Thus, the handover zone 50 in Fig. 7 is much shorter than the handover zone 50 In Figs. 1 to 4. The read heads 31, 32 have a length 39 in the motion direction 11, so that the handover zone 50 can be calculated as two times the length 39.

In Fig. 7, the first read head 31 is positioned over the first scale 33, whereas the second read head 32 Is already positioned out of the handover zone 50, namely entirely over the second scale 34. At that state, the second read head 32 can read the second scale 34 and adopts his reading result from the first read head 31.

With the embodiment shown in Fig. 7 it is also possible to avoid a long scale mounted along the entire length along which the supporting means 10 can be moved. However, since there are no spaces 37, 38 (Fig. 1 to Fig. 4) between the scales 33, 34, 45, altogether more scales are required to be mounted in the second embodiment. Therefore, a positioning system according to the first embodiment is more advantageous.

All of the previously described implementation forms of the
positioning system and the positioning method can be used separately or in all possible combinations thereof, within the scope of the invention. In addition, in particular, the following modifications are conceivable.

The dimensions shown in the drawings are used for illustrating the principle of the invention and are not limiting. The actual dimensions of the positioning system and the components thereof can be selected as appropriate to fulfil the above described functionality.

The number of the read heads 31, 32 can be more than two, even if the figures only show two read heads.

The number of the scales 33, 34, 35 can be at least two and can be more than three.

The length of each of the scales 33, 34, 35 in the motion direction 11 can be different, as shown in Figs. 1 to 4 and 7. However, it is more preferable, that all of the scales 33, 34, 35 have approximately the same length. Therewith, the control which is to be performed by the control means 20 is simplified.

It is advantageous, that the length of each of the scales 33, 34, 35 in the motion direction 11 is longer than a space between the at least two read heads 31, 32.

The spaces 37, 38 between the scales 33, 34, 35 can be shorter or longer compared to the length of the scales 33, 34, 35. It is advantageous, to adjust the length of the scales 33, 34, 35 to the length 39 of the read heads 31, 32 and the length of the supporting means 10 in the motion direction 11 of the supporting means 10, respectively, to achieve the above-described functionality.

The handover zone 50 can include one digit of the first scale 33 and one digit of the second scale 34, i.e. two digits of the two adjacent scales, to achieve that the read heads 31, 32 leaving the hand over zone 50 can securely read the scale over which they are positioned.

The scales can be scales for measuring dimensions in the range of nanometers, for example. That Is, the dimensions can be in the range of meters to picometers or less, however, preferably, in the range of millimeters to picometers or less. In the case of the supporting means being a stage for supporting a wafer, it is preferable that the scales are scales for measuring dimensions in the range of at least nanometers, i.e. nanometers or less, for example 10 to 100 pm.

## Claims

1. Positioning system including:
a positioning device (30) for positioning supporting means (10) for supporting an article (2), and
a supporting means (10) for supporting an article (2), to be positioned,
wherein the positioning device (30) comprises:
at least two scales (33, 34, 35) for measuring the position of said supporting means (10),
a base frame (36) on which said at least two scales (33, 34, 35) are mounted, and
at least two read heads (31, 32) for reading said at least two scales (33, 34, 35),
wherein each one of said at least two read heads (31, 32) is mounted at said supporting means (10) and movable together with said supporting means (10) in a motion direction (11) along a linear line in reciprocating motion, and
wherein each one of said at least two read heads (31, 32) is positioned such that at least one read head (31) of said at least two read heads (31, 32) can read one scale (33) of said at least two scales (33, 34, 35), when said at least two read heads (31, 32) are moved together with said supporting means (10) in said motion direction (11),
wherein said at least two scales (33, 34, 35) are arranged spaced to each other in said direction (11) in which said supporting means (10) is movable, or
wherein said at least two scales (33, 34, 35) are arranged directly adjacent to each other in said direction (11) in which said supporting means (10) is movable.

2. Positioning system according to claim 1, wherein, in the positioning device (30), a mark (51; 52) is arranged between said at least two scales (33, 34, 35).

3. Positioning system according to one of the preceding claims, wherein, in the positioning device (30), each of said at least two read heads (31, 32) is positioned to read a scale (33) which is different from a scale (34) which can be read by another one of said at least two read heads (31, 32).

4. Positioning system according to one of the preceding claims, wherein, in the positioning device (30), said at least two read heads (31, 32) are arranged such that, when one read head (32) enters a range for reading one (34) of said at least two scales (33, 34, 35), said read head (32) adopts its reading result from one (31) of the other at least two read heads (31, 32) which is reading another scale (33) of the at least two scales (33, 34, 35).

5. Positioning system according to one of the preceding claims, wherein said supporting means (10) is a stage for supporting a wafer (2)

6. Positioning system according to one of the preceding claims, wherein, in the positioning device (30), said at least two scales (33, 34, 35) are scales (33, 34, 35) for measuring dimensions in the range of millimeters to picometers.

7. Machine (1; 3) for treating a semiconductor wafer (2), comprising
a positioning system according to one of the preceding claims for positioning the semiconductor wafer (2) in the machine (1; 3).

8. Method for positioning supporting means for supporting an article, comprising the steps of
measuring (S1) the position of said supporting means (10) by the use of at least two scales (33, 34, 35) which are mounted on a base frame (36), and
reading (S2) said at least two scales (33, 34, 35) by at least two read heads (31, 32),
wherein each one of said at least two read heads (31, 32) is mounted at said supporting means (10) and moved together with said supporting means (10) in a motion direction (11) along a linear line in reciprocating motion, and
wherein each one of said at least two read heads (31, 32) is positioned such that at least one read head (31) of said at least two read heads (31, 32) can read one scale (33) of said at least two scales (33, 34, 35), when said at least two read heads (31, 32) are moved together with said supporting means (10) in said motion direction (11),
wherein said at least two scales (33, 34, 35) are arranged spaced to each other in said direction (11) in which said supporting means (10) is movable, or
wherein said at least two scales (33, 34, 35) are arranged directly adjacent to each other in said direction (11) in which said supporting means (10) is movable.

## Patentansprüche

1. Positionierungssystem, Folgendes umfassend:
eine Positionierungsvorrichtung (30) zum Positionieren eines Hilfsmittels (10) zum Stützen eines Artikels (2), und
ein Hilfsmittel (10) zum Stützen eines Artikels (2), der positioniert werden soll,
wobei die Positionierungsvorrichtung (30) Folgendes umfasst:
mindestens zwei Skalen (33, 34, 35) zum Messen der Position des Hilfsmittels (10),
einen Grundrahmen (36), auf dem die mindestens zwei Skalen (33, 34, 35) befestigt sind, und
mindestens zwei Leseköpfe (31, 32) zum Lesen der mindestens zwei Skalen (33, 34, 35),
wobei jeder der mindestens zwei Leseköpfe (31, 32) an dem Hilfsmittel (10) befestigt ist und zusammen mit dem Hilfsmittel (10) in einer Bewegungsrichtung (11) entlang einer linearen Linie in einer Hin- und Herbewegung beweglich ist, und
wobei jeder der mindestens zwei Leseköpfe (31, 32) derartig positioniert ist, dass mindestens ein Lesekopf (31) der mindestens zwei Leseköpfe (31, 32) eine Skala (33) der mindestens zwei Skalen (33, 34, 35) lesen kann, wenn die mindestens zwei Leseköpfe (31, 32) zusammen mit dem Hilfsmittel (10) in der Bewegungsrichtung (11) bewegt werden,
wobei die mindestens zwei Skalen (33, 34, 35) in der Richtung (11), in die das Hilfsmittel (10) beweglich ist, voneinander beabstandet angeordnet sind, oder
wobei die mindestens zwei Skalen (33, 34, 35) in der Richtung (11), in die das Hilfsmittel (10) beweglich ist, unmittelbar benachbart zueinander angeordnet sind.

2. Positionierungssystem nach Anspruch 1, wobei in der Positionierungsvorrichtung (30) eine Marke (51; 52) zwischen den mindestens zwei Skalen (33, 34, 35) angeordnet ist.

3. Positionierungssystem nach einem der vorhergehenden Ansprüche, wobei jeder der mindestens zwei Leseköpfe (31, 32) in der Positionierungsvorrichtung (30) positioniert wird, um eine Skala (33) zu lesen, die von einer Skala (34) verschieden ist, die durch einen anderen der mindestens zwei Leseköpfe (31, 32) gelesen werden kann.

4. Positionierungssystem nach einem der vorhergehenden Ansprüche, wobei die mindestens zwei Leseköpfe (31, 32) derartig in der Positionierungsvorrichtung (30) angeordnet sind, dass, wenn ein Lesekopf (32) in einen Bereich zum Lesen einer (34) der mindestens zwei Skalen (33, 34, 35) eintritt, der Lesekopf (32) sein Leseergebnis aus einem (31) der anderen mindestens zwei Leseköpfe (31, 32) übernimmt, der eine andere Skala (33) der mindestens zwei Skalen (33, 34, 35) liest.

5. Positionierungssystem nach einem der vorhergehenden Ansprüche, wobei das Hilfsmittel (10) ein Tisch zum Stützen eines Wafers (2) ist.

6. Positionierungssystem nach einem der vorhergehenden Ansprüche, wobei die mindestens zwei Skalen (33, 34, 35) in der Positionierungsvorrichtung (30) Skalen (33, 34, 35) zum Messen von Abmessungen im Bereich von Millimetern bis Pikometern sind.

7. Maschine (1; 3) zum Behandeln eines Halbleiter-Wafers (2), umfassend ein Positionierungssystem nach einem der vorhergehenden Ansprüche zum Positionieren des Halbleiter-Wafers (2) in der Maschine (1; 3).

8. Verfahren zum Positionieren eines Hilfsmittels zum Stützen eines Artikels, die folgenden Schritte umfassend:
Messen (S1) der Position des Hilfsmittels (10) durch Verwendung von mindestens zwei Skalen (33, 34, 35), die auf einem Grundrahmen (36) befestigt sind, und
Lesen (S2) der mindestens zwei Skalen (33, 34, 35) durch mindestens zwei Leseköpfe (31, 32),
wobei jeder der mindestens zwei Leseköpfe (31, 32) an dem Hilfsmittel (10) befestigt ist und zusammen mit dem Hilfsmittel (10) in einer Bewegungsrichtung (11) entlang einer linearen Linie in einer Hin- und Herbewegung bewegt wird, und
wobei jeder der mindestens zwei Leseköpfe (31, 32) derartig positioniert ist, dass mindestens ein Lesekopf (31) der mindestens zwei Leseköpfe (31, 32) eine Skala (33) der mindestens zwei Skalen (33, 34, 35) lesen kann, wenn die mindestens zwei Leseköpfe (31, 32) zusammen mit dem Hilfsmittel (10) in der Bewegungsrichtung (11) bewegt werden,
wobei die mindestens zwei Skalen (33, 34, 35) in der Richtung (11), in die das Hilfsmittel (10) beweglich ist, voneinander beabstandet angeordnet sind, oder
wobei die mindestens zwei Skalen (33, 34, 35) in der Richtung (11), in die das Hilfsmittel (10) beweglich ist, unmittelbar benachbart zueinander angeordnet sind.

## Revendications

1. Système de positionnement comprenant :
un dispositif de positionnement (30) pour positionner un moyen de support (10) pour supporter un article (2), et
un moyen de support (10) pour supporter un article (2) à positionner,
où le dispositif de positionnement (30) comprend :
au moins deux échelles (33, 34, 35) pour mesurer la position dudit moyen de support (10),
un châssis de base (36) sur lequel sont montées lesdites au moins deux échelles (33, 34, 35), et
au moins deux têtes de lecture (31, 32) pour lire lesdites au moins deux échelles (33, 34, 35),
où chacune desdites au moins deux têtes de lecture (31, 32) est montée sur ledit moyen de support (10) et est mobile avec ledit moyen de support (10) dans une direction de déplacement (11) le long d'une ligne linéaire suivant un mouvement alternatif, et
où chacune desdites au moins deux têtes de lecture (31, 32) est positionnée de telle sorte qu'au moins une tête de lecture (31) desdites au moins deux têtes de lecture (31, 32) puisse lire une échelle (33) desdites au moins deux échelles (33, 34, 35), lorsque lesdites au moins deux têtes de lecture (31, 32) sont déplacées avec ledit moyen de support (10) dans ladite direction de déplacement (11),
où lesdites au moins deux échelles (33, 34, 35) sont disposées espacées l'une de l'autre dans ladite direction (11) dans laquelle ledit moyen de support (10) est mobile, ou
où lesdites au moins deux échelles (33, 34, 35) sont disposées directement adjacentes l'une à l'autre dans ladite direction (11) dans laquelle ledit moyen de support (10) est mobile.

2. Système de positionnement selon la revendication 1, dans lequel, dans le dispositif de positionnement (30), une marque (51 ; 52) est disposée entre lesdites au moins deux échelles (33, 34, 35).

3. Système de positionnement selon l'une des revendications précédentes, dans lequel, dans le dispositif de positionnement (30),
chacune desdites au moins deux têtes de lecture (31, 32) est positionnée pour lire une échelle (33) qui est différente d'une échelle (34) qui peut être lue par une autre desdites au moins deux têtes de lecture (31, 32).

4. Système de positionnement selon l'une des revendications précédentes, dans lequel, dans le dispositif de positionnement (30),
lesdites au moins deux têtes de lecture (31, 32) sont agencées de telle sorte que, lorsqu'une tête de lecture (32) entre dans une plage de lecture d'une (34) desdites au moins deux échelles (33, 34, 35), ladite tête de lecture (32) adopte son résultat de lecture d'une (31) des autres au moins deux têtes de lecture (31, 32) qui lit une autre échelle (33) des au moins deux échelles (33, 34, 35).

5. Système de positionnement selon l'une des revendications précédentes, dans lequel ledit moyen de support (10) est une platine pour supporter une plaquette (2).

6. Système de positionnement selon l'une des revendications précédentes, dans lequel, dans le dispositif de positionnement (30),
lesdites au moins deux échelles (33, 34, 35) sont des échelles (33, 34, 35) pour mesurer des dimensions dans une plage s'étendant des millimètres aux picomètres.

7. Machine (1 ; 3) pour le traitement d'une plaquette semi-conductrice (2), comprenant :
un système de positionnement selon l'une des revendications précédentes pour le positionnement de la plaquette semi-conductrice (2) dans la machine (1 ; 3).

8. Procédé de positionnement d'un moyen de support pour supporter un article, comprenant les étapes suivantes :
mesurer (S1) la position dudit moyen de support (10) en utilisant au moins deux échelles (33, 34, 35) qui sont montées sur un châssis de base (36), et
lire (S2) lesdites au moins deux échelles (33, 34, 35) au moyen d'au moins deux têtes de lecture (31, 32),
où chacune desdites au moins deux têtes de lecture (31, 32) est montée sur ledit moyen de support (10) et est mobile avec ledit moyen de support (10) dans une direction de déplacement (11) le long d'une ligne linéaire suivant un mouvement alternatif, et
où chacune desdites au moins deux têtes de lecture (31, 32) est positionnée de telle sorte qu'au moins une tête de lecture (31) desdites au moins deux têtes de lecture (31, 32) puisse lire une échelle (33) desdites au moins deux échelles (33, 34, 35), lorsque lesdites au moins deux têtes de lecture (31, 32) sont déplacées avec ledit moyen de support (10) dans ladite direction de déplacement (11),
où lesdites au moins deux échelles (33, 34, 35) sont disposées espacées l'une de l'autre dans ladite direction (11) dans laquelle ledit moyen de support (10) est mobile, ou
où lesdites au moins deux échelles (33, 34, 35) sont disposées directement adjacentes l'une à l'autre dans ladite direction (11) dans laquelle ledit moyen de support (10) est mobile.
